Europäisches Patentamt

European Patent Office

Office européen des brevets

(19)

(11) Numéro de publication: **0 052 027**
**B1**

## (12) FASCICULE DE BREVET EUROPEEN

(45) Date de publication du fascicule du brevet:
14.03.84

(51) Int. Cl.³: **H 03 K 4/72**, G 09 G 3/04 //
H04N3/16

(21) Numéro de dépôt: 81401583.0

(22) Date de dépôt: 13.10.81

(54) **Dispositif de commande du courant de balayage trame pour un récepteur de télévision, et récepteur comportant un tel dispositif.**

(30) Priorité: 07.11.80 FR 8023879

(43) Date de publication de la demande:
19.05.82 Bulletin 82/20

(45) Mention de la délivrance du brevet:
14.03.84 Bulletin 84/11

(84) Etats contractants désignés:
DE GB IT NL SE

(56) Documents cités:
EP - A - 0 008 263
FR - A - 2 465 381

(73) Titulaire: THOMSON-BRANDT, 173, Boulevard
Haussmann, F-75379 Paris Cedex 08 (FR)

(72) Inventeur: Vacher, Michel, THOMSON-CSF SCPI 173, bld
Haussmann, F-75360 Paris Cedex 08 (FR)

(74) Mandataire: Grynwald, Albert et al, THOMSON-CSF
SCPI 173, Bld Haussmann, F-75379 Paris Cedex 08 (FR)

BUNDESDRUCKEREI BERLIN

# Dispositif de commande du courant de balayage trame pour un récepteur de télévision et récepteur comportant un tel dispositif

L'invention est relative à un dispositif de commande du courant de balayage pour un récepteur de télévision et à un récepteur comportant un tel dispositif.

On sait que pour obtenir l'impression du mouvement, en télévision, comme en cinéma, on projette une suite d'images fixes. Mais la télévision a la particularité que les points de chaque image ne sont pas projetés simultanément mais de façon successive sur l'écran. A cet effet, un récepteur de télévision comprend un canon à électrons émettant un pinceau d'électrons frappant à chaque instant, en un point, l'écran recouvert d'une substance cathodoluminescente, l'intensité du pinceau d'électrons étant fonction de la luminosité du point de l'image. Le balayage de l'écran s'effectue selon des lignes horizontales en commençant par la ligne supérieure; il est obtenu grâce à des champs magnétiques variables qui déplacent le pinceau et qui sont engendrés par des courants électriques traversant des bobines. On prévoit une bobine de déviation horizontale pour effectuer le balayage selon des lignes et une bobine de déviation verticale, ou bobine de trame, pour effectuer le passage d'une ligne à une autre.

Dans la pratique, le balayage de l'écran pour obtenir une image s'effectue selon deux demi-trames: dans un balayage à six cent vingt cinq lignes la ligne numéro 1 est en haut de l'écran, la trois cent douzième ligne est en bas de l'écran, la trois cent treizième ligne est en haut de l'écran, entre la première et la seconde ligne, les lignes 313 à 624 se trouvent également entre deux lignes de la première demi-trame et la dernière ligne (n° 625) est en bas de l'écran. Un tel balayage s'appelle un balayage par demi-trames entrelacées. Dans ce qui suit, pour simplifier, on ne distinguera pas une trame et une demi-trame.

L'intensité du courant circulant dans la bobine de déviation verticale (appelée encore déviateur vertical ou déviateur trame), augmente de la première à la dernière ligne.

L'invention vise un dispositif de balayage trame, tel que celui décrit dans le brevet européen 8 263, dans lequel le déviateur vertical est alimenté par un générateur comportant, en série, un interrupteur actif qui est commandé de façon qu'à chaque ligne il soit conducteur pendant une fraction de la période de balayage de cette ligne qui dépend du numéro de la ligne.

Selon l'invention pour la commande de l'interrupteur actif on prévoit: deux mémoires (51, 52) dont le contenu de chacune est modifiable et dont chacune est destinée à contenir un ensemble de mots binaires représentant chacun la durée de conduction pour une ligne déterminée, et de moyens de commutation (54, 54', 60, 65, 71) pour qu'au cours d'une période balayage trame le contenu d'une mémoire soit utilisé pour le balayage et le contenu de l'autre mémoire puisse être modifié, le contenu modifié étant utilisé au cours du balayage d'une trame suivante afin que cette modification soit effectuée sans perturbation sur l'image retransmise.

On ne risque ainsi pas de perturber l'image au cours d'une trame et on peut disposer d'un temps important pour modifier ladite suite de mots binaires.

D'autres dispositions de l'invention apparaîtront avec la description de certains de ses modes de réalisation, celle-ci étant effectuée en se référant aux dessins ci-annexés sur lesquels:

la figure 1 est un schéma représentant un déviateur vertical et son dispositif de commande selon l'invention,

la figure 2 est un diagramme de signaux appliqués sur l'électrode de commande de l'interrupteur actif du dispositif de la demande figure 1,

la figure 3 est un organigramme montrant la programmation d'un micro-processeur faisant partie du dispositif de la figure 1,

la figure 4 est un diagramme correspondant à une variante de la figure 3, et

la figure 5 montre une partie d'un dispositif de commande selon l'invention, pour une variante simplifiée de la figure 1.

Le circuit 1 dans lequel est inséré le déviateur vertical 2 est du type de celui décrit dans le brevet européen n° 8 263 au nom de la demanderesse, c'est-à-dire que, pour engendrer le courant de déviation trame, on fait appel à l'énergie tirée du déviateur ligne (non montré) grâce à un transformateur 3 dont le primaire est couplé à ce déviateur et présentant un enroulement secondaire 4 en série avec une inductance 5, un condensateur 6 et un interrupteur actif 7. Ce dernier, qui est bidirectionnel en courant, comprend un thyristor 8 et une diode 9 montés en sens inverse. Dans l'exemple la cathode du thyristor 8 et l'anode de la diode 9 sont connectées à la masse, de même que l'armature du condensateur 6 qui es opposée à celle reliée à l'inductance 5. Le signal de sortie est tiré du condensateur 6. Le déviateur 2 est en série avec un condensateur 11 et une résistance de mesure 12. Une borne de ce déviateur est connectée à la borne commune 10 au condensateur 6 et à l'inductance 5 et la borne de la résistance 12 opposée au condensateur 11 est reliée à la masse.

La capacité du condensateur 11 est de valeur suffisante pour que la tension aux bornes de l'ensemble formé par la bobine 2, le condensateur 11 et la résistance 12 garde une même polarité quelque soit le sens du courant traversant le déviateur. Cet ensemble se comporte alors tantôt en récepteur tantôt en générateur d'énergie, ce qui permet, outre une économie sur la puissance d'alimentation, d'utiliser un interrupteur 7 dans lequel le courant peut circuler dans les deux sens, ce qui autorise l'utilisation d'un circuit d'alimentation à un seul canal.

Egalement comme décrit dans ledit brevet l'interrupteur actif 7 est commandé — par l'application d'un signal sur la gâchette 13 du thyristor 8 — de manière telle que cet interrupteur ne soit conducteur que pendant une fraction de chaque période de balayage ligne, cette fraction étant fonction du numéro de la ligne.

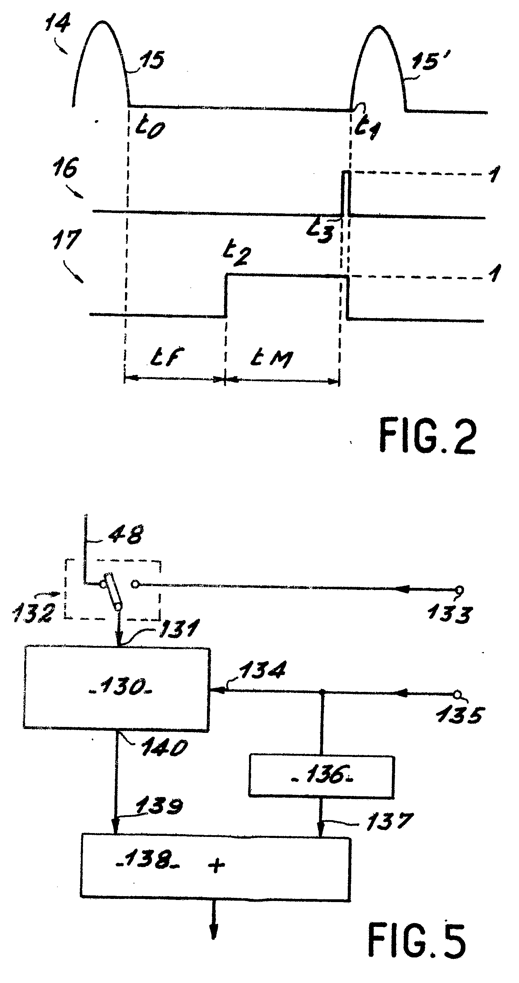

Sur la figure 2 on a représenté par la courbe 14 les variations en fonction du temps de l'impulsion 15 de retour ligne, le balayage ligne s'effectuant entre l'instant $t_0$ de fin d'une telle impulsion et le début $t_1$ de l'impulsion 15' suivante.

Les courbes 16 et 17 représentent les variations en fonction du temps de l'état de conduction du thyristor 8 pour, respectivement, la première ligne — c'est-à-dire le début d'une trame — et la trois cent douzième ligne — c'est-à-dire la fin d'une trame ou demi-trame.

La conduction du thyristor correspond au niveau haut repéré 1 sur la figure 2.

On voit ainsi que le thyristor n'est conducteur que pendant une courte période $(t_3 - t_1)$ au cours de la première ligne alors qu'il est conducteur pendant une période beaucoup plus importante $(t_2 - t_1)$ au cours du balayage de la dernière ligne, le courant fourni au déviateur 2 augmentant ainsi de façon progressive de la première à la dernière ligne. Cependant même lors du balayage de la dernière ligne le thyristor n'est pas conducteur au début de la période de balayage ligne; il s'écoule un temps $t_f$ non nul entre l'instant $t_0$ et l'instant $t_2$ de début de conduction du thyristor au cours du balayage de la dernière ligne.

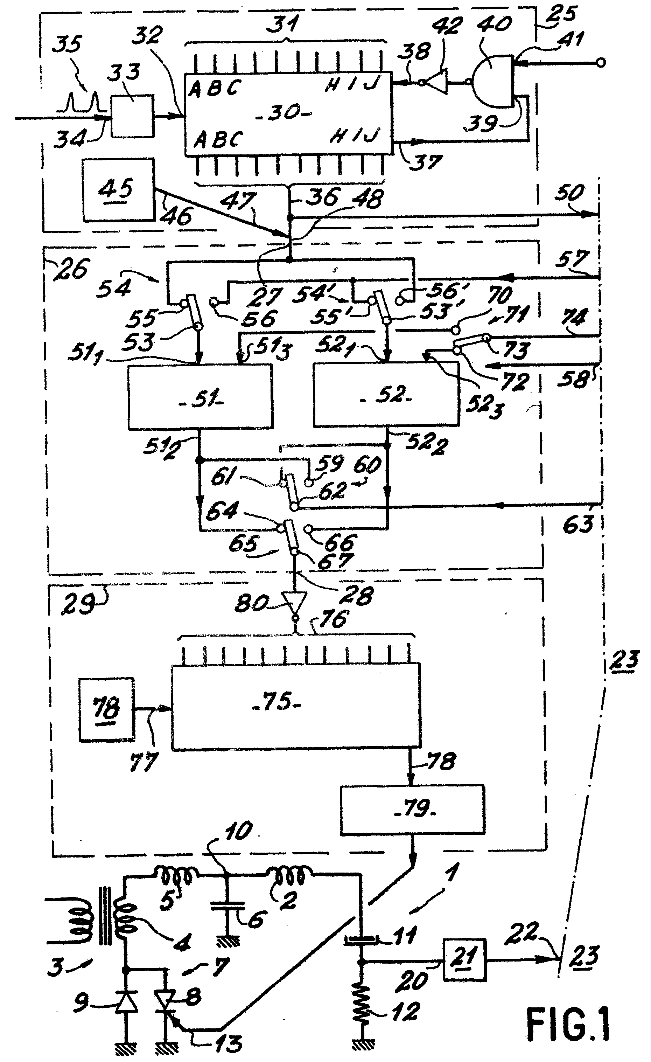

Selon une disposition de l'invention la tension aux bornes de la résistance de mesure 12 (fig. 1), qui représente l'intensité du courant traversant le déviateur 2, est appliquée à l'entrée 20 d'un convertisseur analogique/numérique 21 dont la sortie est connectée à une entrée 22 d'un micro-processeur 23 faisant partie du dispositif de commande engendrant les signaux appliqués sur l'électrode de commande 13 du thyristor 8.

Ce dispositif de commande comprend également un étage 25 de comptage des lignes, un étage 26 générateur de mots binaires permettant de transformer un numéro de ligne appliqué sur son entrée 27 en un nombre binaire, apparaissant sur sa sortie 28, représentant la durée de conduction du thyristor pour cette ligne.

Entre la sortie 28 de l'étage 26 et l'électrode 13 est disposé un étage 29 de conversion du nombre binaire provenant de la sortie 28 en une impulsion rectangulaire du type de celle représentée par la courbe 16 ou 17 sur la figure 2 dont la durée est fonction de la valeur dudit nombre binaire.

L'étage 25 de comptage des lignes comporte un décompteur 30 à entrées parallèles 31 de présélection sur lesquelles sont appliquées, en début de balayage trame, des signaux correspondant au nombre 625 c'est-à-dire au nombre de lignes, et à entrée de décomptage 32 reliée à la sortie d'un doubleur d fréquence 33 sur l'entrée 34 duquel sont appliquées des impulsions 35 à la fréquence de balayage ligne. Le décompteur 30 présente également des sorties parallèles 36, une sortie série 37 sur laquelle apparaît un »0« lorsque le contenu de compteur 38 est nul et une autre entrée série 38 de commande du chargement permettant l'introduction dans le compteur du nombre présenté sur les entrées 31 lorsqu'un »0« est appliqué sur cette entrée 38. La sortie 37 est reliée à la première entrée 39 d'une porte ET NON 40 dont la seconde entrée 41 reçoit un signal de synchronisation trame et dont la sortie est connectée à l'entrée 38 du décompteur 30 par l'intermédiaire d'un inverseur 42.

Le doubleur de fréquence 33 permet de compter un nombre entier (625) à chaque demi trame.

Un signal »0« est appliqué sur l'entrée 41 de la porte 40 lorsqu'il est nécessaire de resynchroniser le balayage trame au balayage ligne par exemple à la mise en route du téléviseur ou lors d'un changement de programme.

L'étage 25 de comptage des lignes comporte également un organe 45 de décodage fournissant sur sa sortie 46 un chiffre binaire, c'est-à-dire un nombre binaire à un seul bit, 0 ou 1, représentant le numéro de la demi-trame c'est-à-dire indiquant si on est en cours de balayage de la première ou de la seconde demi-trame.

Les conducteurs formant les sorties parallèles 36 du décompteur 30 ainsi que le conducteur 47 relié à sortie 46 de l'organe 45 sont rassemblés pour former une ligne 48 qui est de façon classique représentée par un seul trait. L'entrée 27 de l'étage 26 est donc une entrée parallèle bien qu'elle n'ait été représentée que par un seul point.

Le nombre binaire, constitué de chiffres binaires, apparaisant sur la ligne 48 est appliqué sur une entrée 50 du micro-processeur 23.

L'étage 26 comporte deux mémoires vives (RAM) identiques 51 et 52 destinées chacune à stocker 625 mots de 12 bits chacun. L'entrée d'adressage $51_1$ de la mémoire 51 est reliée à la borne commune 53 d'un commutateur 54 présentant une borne 55 reliée à l'entrée 27 et une autre borne 56 connectée à une sortie 57 du micro-processeur 23. Selon l'état du commutateur 54 l'entrée $51_1$ de la mémoire 51 est reliée soit à l'entrée 27 de l'étage 26 soit à la sortie 57 du micro-processeur 23. La commande de l'état du commutateur 54 est effectuée à l'aide d'un signal fourni par une autre sortie 58 dudit micro-processeur.

De manière analogue l'entrée d'adressage $52_1$ de la mémoire 52 est reliée à la borne commune 53' d'un commutateur 54' comportant une autre borne 55' reliée à la sortie 57 du micro-processeur 23 et une borne 56' reliée à l'entrée 27 de l'étage 26. L'état de ce commutateur 54' est également fonction de la valeur du signal sur la sortie 58 du micro-processeur 23. L'entrée-sortie de données $51_2$ de la mémoire 51 est connectée à une borne 59 d'un commutateur 60 dont une autre borne 61 est reliée à l'entrée-sortie $52_2$ de la mémoire 52 et dont la borne commune 62 est reliée à une sortie 63 du micro-processeur 23. L'état du commutateur 60 dépend également de la valeur du signal sur la sortie 58. Les sorties $51_2$ et $52_2$ sont du type parallèle à 12 bits. Il en est bien entendu de même de la sortie 63 du micro- processeur 23.

L'entrée-sortie $51_2$ est également connectée à la première borne 64 d'un autre commutateur 65 à deux positions présentant une seconde borne 66 reliée à l'entrée-sortie $52_2$ de la mémoire 52 ainsi qu'une borne commune 67 reliée à la sortie 28 de l'étage 26.

Les états des commutateurs 60 et 65 dépendent également de la valeur du signal sur la sortie 58 du micro-processeur 23.

La mémoire 51 comporte une entrée $51_3$ de commande d'écriture reliée à une borne 70 d'un commutateur 71 à deux positions dont une autre borne 72 est reliée à l'entrée d'écriture $52_3$ de la mémoire 52 et dont la borne commune 73 est connectée à une sortie 74 du micro-processeur 23 sur laquelle apparait un signal à 1 bit représentant une commande d'écriture. La position du commutateur 71 dépend, comme celle de tous les autres commutateurs, du signal sur la sortie 58.

Dans la condition représentée sur la figure 1 l'entrée d'adressage $51_1$ de la mémoire 51 est reliée à l'entrée 27 de l'étage 26, aucun signal n'est appliqué sur l'entrée $51_3$ et l'entrée-sortie $51_2$, constituant alors une sortie, est reliée à la sortie 28 de l'étage 26. La mémoire 51 délivre ainsi un mot de 12 bits représentant la durée de conduction du thyristor 8 au cours de la période de balayage trame.

L'entrée $52_1$ d'adressage de la mémoire 52 est reliée à la sortie 57 du micro-processeur, un signal est appliqué sur l'entrée $52_3$ de commande d'écriture et l'entrée-sortie $52_2$, qui constitue alors une entrée, est connectée à la sortie 63 du micro-processeur 23. Ainsi le contenu de la mémoire vive 52 est modifié, les chiffres à introduire dans cette mémoire étant fournis par le micro-processeur.

Lorsque le signal sur la sortie 58 du micro-processeur prend la valeur opposée les positions des commutateurs 54, 54', 60, 65 et 71 changent simultanément et, dans ce cas, c'est la mémoire 52 qui délivre les mots binaires de commande de la conduction du thyristor 8 et c'est le contenu de la mémoire 51 qui peut être modifié grâce aux données fournies par le micro-processeur 23.

Dans un exemple la modification du contenu d'une mémoire, 51 ou 52, s'effectue en 60 ms. Si l'étage 26 ne contenait qu'une seule mémoire la modification du contenu de cette dernière pourrait perturber le balayage car cette durée de chargement de la mémoire (60 ms) est nettement plus longue que la durée de retour trame. Le risque de perturbation est évité avec la disposition de l'invention selon laquelle on prévoit deux mémoires identiques, la modification des mots d'une mémoire s'effectuant lorsque celle-ci n'est pas utilisée pour commander le thyristor.

Le changement de position des commutateurs 54, 54', 60, 65 et 71 s'effectue en un temps négligeable, de l'ordre de 20 nanosecondes dans l'exemple, bien inférieur à la durée de retour-trame et peut donc s'effectuer pendant cette période de retour trame, ce qui ne perturbe donc pas l'image.

L'étage 29 comprend un compteur 75 dont les entrées parallèles 76 sont reliées à la sortie 28 de l'étage 26 par l'intermédiaire d'un inverseur 80 et dont l'entrée de comptage 77 est connectée à la sortie d'un générateur 78 d'un signal d'horloge à la fréquence de 50 MHz, c'est-à-dire nettement supérieure à la fréquence de balayage ligne. Un signal apparait sur la sortie 78 du compteur 75 lorsque son entrée 77 a reçu un nombre de signaux d'horloge égal au nombre appliqué sur les entrées 76. Ce signal est transmis à l'électrode 13 du thyristor 8 par l'intermédiaire d'un dispositif 79 de mise en forme.

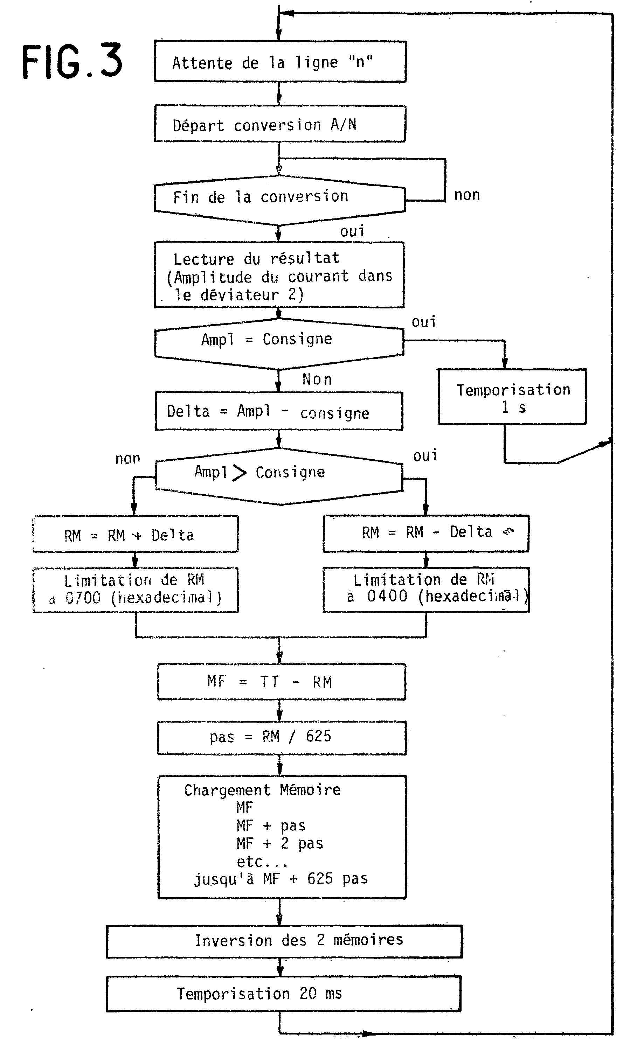

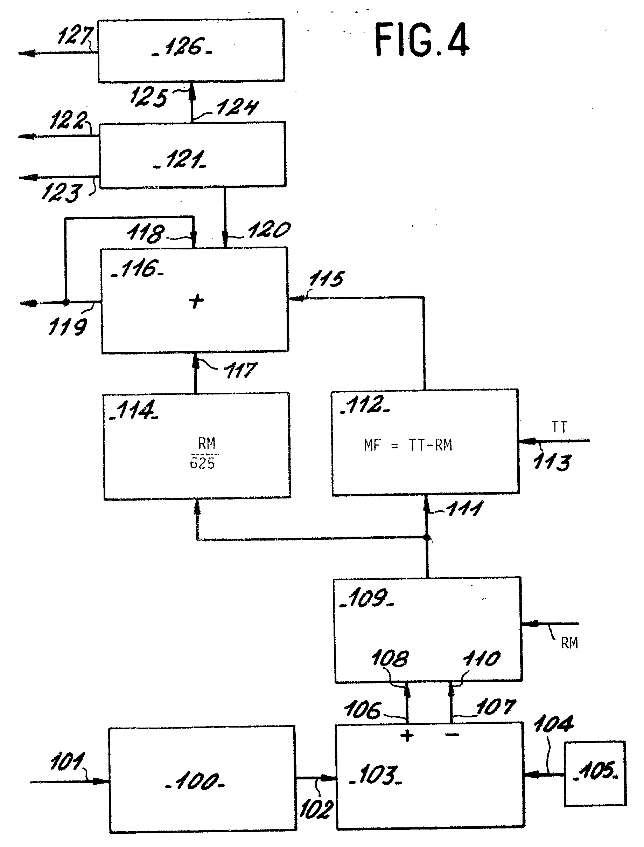

Les figures 3 et 4 sont des organigrammes représentant la programmation du micro-processeur 23 qui permet de charger une mémoire 51 ou 52 par un ensemble de mots binaires à 12 bits chacun qui est fonction de l'intensité du courant dans le déviateur 2, c'est-à-dire du signal appliqué sur l'entrée 22. Ce micro-processeur contient en mémoire, pour chaque ligne, des valeurs de consigne du courant dans le déviateur 2. Si l'intensité de ce courant, mesurée par le signal appliqué sur l'entrée 22, ne correspond pas à la consigne pour le numéro de ligne appliqué sur l'entrée 50, le micro-processeur modifie le contenu de l'une des mémoires pour ramener cette intensité du courant dans le déviateur 2 à la valeur de consigne.

L'intensité du courant ans le déviateur 2 peut s'écarter de la valeur de consigne en mémoire du micro-processeur 23 en raison, par exemple, du vieillissement de certains de ses éléments qui se traduit notamment par une variation de la résistance de la bobine. L'intensité s'écarte également de la consigne lorsque la tension d'alimentation est modifiée et fait ainsi varier la tension apparaissant aux bornes de l'enroulement secondaire 4 du transformateur 3. L'écart entre l'intensité du courant dans le déviateur 2 et l'intensité de consigne en mémoire peut être également dû à des variations de température.

Comme le montre la figure 3 la mesure est effectuée périodiquement, toutes les secondes dans l'exemple.

Sur l'organigramme de la figure 3 »Ampl« signifie Amplitude, RM est la valeur maximale du nombre binaire qu'on peut introduire dans une mémoire vive 51 ou 52, TT est la valeur correspondant à la durée $t_f + t_M$ (fig. 2), et MF signifie »mot fixe« c'est-à-dire un mot binaire correspondant à la durée $t_f$ (fig. 2).

Enfin, à propos de la figure 3, on notera que »hexadécimal« signifie que les nombres 0700 et 0400 sont hexadécimaux.

La figure 4 représente un ensemble d'éléments assurant les mêmes fonctions que celles réalisées par le micro-processeur programmé comme représenté sur la figure 3, c'est-à-dire un montage pouvant remplacer ce micro-processeur.

Ce montage comprend un convertisseur analogique-numérique 100 dont l'entrée 101 reçoit un signal égal à la tension aux bornes de la résistance de mesure 12 et dont la sortie est reliée à une première entrée 102 d'un comparateur 103 sur la seconde entrée 104 duquel est appliqué un signal provenant d'une mémoire 105 dans laquelle sont stockées les valeurs de consigne de l'intensité du courant de balayage trame pour les diverses lignes.

Le comparateur 103 délivre un signal égal à Delta (Amplitudeconsigne; figure 3) sur une première sortie 106 (+) lorsque l'amplitude du signal sur l'entrée 102 est supérieure à l'amplitude du signal sur l'entrée 104 de consigne. Dans le cas contraire, c'est-à-dire si le signal mesuré appliqué sur l'entrée 102 inférieur au signal de consigne sur l'entrée 104, le comparateur produit un signal égal à Delta sur une sortie 107 (−).

La sortie 106 est reliée à l'entrée 108 de décomptage d'un compteur-décompteur 109 tandis que la sortie 107 du comparateur 103 est connectée à l'entrée 110 de comptage dudit compteur 109.

Le compteur-décompteur 109 est chargé à l'instant $t_0$ par un nombre, appelé RM, correspondant au temps $t_M$ (figure 2) qui est égal à la différence entre les retards, par rapport à l'instant $t_0$, de déclenchement du thyristor 8 lors des balayages d'une part de la première ligne et d'autre part de la dernière ligne.

La sortie du compteur-décompteur 109 est ainsi RM + Delta ou RM − Delta. Elle est appliquée à la première entrée 111 d'un soustracteur 112 sur la seconde entrée 113 duquel est appliqué le nombre fixe TT correspondant à la durée $t_f + t_M$. En sortie de ce soustracteur on obtient:

MF = TT − RM;
MF représente la durée $t_f$ (figure 2).

La sortie du compteur-déxcompteur 109 est également reliée à l'entrée d'un diviseur 114 dont le facteur de division est 625.

La sortie du soustracteur 112 est reliée à l'entrée 115 de commande du chargement d'un additionneur 116 à deux entrées de données, l'une, de référence 117, connectée à la sortie du diviseur 114 et l'autre, de référence 118, reliée à la sortie 19 de cet additionneur 116.

Le fonctionnement de l'additionneur est commandé par un signal d'horloge appliqué sur une entrée d'horloge 120 et qui est fourni par un générateur de signal d'horloge 121 qui présente une sortie d'écriture 122 reliée à la borne 73 du commutateur 71 (fig. 1), une sortie 123 pour commander les commutateurs 54, 54', 60, 65 et 71 et une sortie 124 reliée à l'entrée de comptage 125 d'un compteur 126 fournissant sur sa sortie 127 un nombre à 10 bits qui est l'adresse dans la mémoire 51 ou 52 du nombre à 12 bits aparaissant sur la sortie 119 de l'additionneur 116.

Cette sortie 119 de l'additionneur 116 est reliée à la borne 62 du commutateur 60.

A chaque signal d'horloge appliqué sur l'entrée 120 de l'additionneur 116, la sortie 119 est augmentée d'un pas correspondant au signal fourni par le diviseur 114 et, en même temps, le compteur 126 est incrémenté pour que la donnée apparaissant sur la sortie 119 soit introduite à l'adresse suivante dans la mémoire 51 ou 52.

On a représenté sur la figure 5 une autre réalisation de l'etage 26 générateur de mots binaires du dispositif de commande de balayage trame.

Dans cette réalisation le générateur comporte une mémoire 130 dont l'entrée d'adressage 131 est connectable, par l'intermédiaire d'un commutateur 132 à deux positions, soit à la ligne 48 de sortie de l'etage 25 (figure 1) soit à la sortie 133 d'un microprocesseur ou de tout autre dispositif fournissant une adresse convenable.

L'entrée 134 de données est connectée à la sortie 135 dudit micro-processeur. Cette sortie 135 est également reliée à l'entrée d'un registre 136 dont la sortie est connectée à la première entrée 137 d'un additionneur 138 dont la seconde entrée 139 est reliée à la sortie de données 140 de la mémoire 130.

La mémoire 130 est une mémoire vive (RAM) pouvant contenir 625 mots de 11 bits chacun. Le registre 136 est une mémoire contenant un mot de 11 bits correspondant au »mot fixe« c'est-à-dire à la durée $t_f$ (figure 2).

En sortie de l'additionneur 138 on obtient un nombre à 12 bits.

Cette réalisation met à profit le fait qu'entre la première et la dernière ligne l'écart maximum entre les retards, par rapport à l'instant $t_0$, de déclenchement du thyristor est au maximum $t_M$, c'est-à-dire nettement inférieur à la durée de balayage ligne. Elle permet d'utiliser une mémoire de moins grande capacité que dans la réalisation représentée sur la figure 1 où la mémoire 51 ou 52 contient 625 mots de 12 bits chacun alors que la mémoire 130 contient 625 mots de 11 bits chacun.

Cependant cette disposition est utilisable dans l'exemple de la figure 1 dans lequel il suffit de remplacer chaque mémoire par l'ensemble formé par la mémoire 130, le registre 136 et l'additionneur 138.

La modification du contenu de la mémoire 130 sera de préférence effectuée à une période susceptible d'être la moins gênante, par exemple tout de suite après la mise sous tension du récepteur de télévision.

Les valeurs de courant de balayage trame se trouvant en mémoire du micro-processeur 23 (ou dans la mémoire 105, figure 4) seront choisies pour que la loi de variation du courant en fonction du temps pour chaque trame ait la forme entrainant un minimum de distorsions de l'image. Les valeurs en mémoire seront donc choisies pour effectuer la correction de linéarité et/ou une correction en S.

## Revendications

1. Dispositif de commande d'un générateur de courant de balayage trame pour récepteur de télévision, ce générateur comprenant un interrupteur actif (7) commandé par ledit dispositif pour être alternativement conducteur et non conducteur au cours de chaque période de balayage ligne, la durée de conduction étant fonction du numéro de la ligne, caractérisé en ce qu'il comporte deux mémoires (51, 52) dont le contenu de chacune est modifiable et dont chacune est destinée à contenir un ensemble de mots binaires représentant chacun la durée de conduction pour une ligne déterminée, et des moyens de commutation (54, 54', 60, 65, 71) pour qu'au cours d'une période balayage trame le contenu d'une mémoire soit utilisé pour le balayage et le contenu de l'autre mémoire puisse être modifié, le contenu modifié étant utilisé au cours du balayage d'une trame suivante afin que cette modification soit effectuée sans perturbation sur l'image retransmise.

2. Dispositif selon la revendication 1, caractérisé en ce que les mémoires sont des mémoires vives.

3. Dispositif selon la revendication 1 ou 2, caractérisé en ce qu'il comporte une mémoire supplémentaire (23, 105) dans laquelle sont stockées, pour les diverses lignes, les valeurs de consigne de l'intensité du courant de balayage, un moyen pour comparer l'intensité de consigne avec l'intensité mesurée et un moyen pour modifier le contenu de la mémoire (51, 52; 130) lorsque le comparateur indique un écart.

4. Dispositif selon la revendication 3, caractérisé en ce qu'il comprend un micro-processeur (23) pour effectuer ladite comparaison et ladite modification.

5. Dispositif selon la revendication 3 ou la revendication 4, caractérisé en ce que les valeurs stockées dans la mémoire supplémentaire tiennent compte de la correction en S et/ou de linéarité.

6. Dispositif selon l'une quelconque des revendications précédentes, caractérisé en ce que chaque mémoire à contenu modifiable comporte un registre (136) dans lequel est stocké un mot binaire correspondant à la plus petite durée ($t_1$) s'écoulant entre le début ($t_0$) d'un balayage ligne et le déclenchement de l'interrupteur actif (7), une mémoire partielle (130) contenant un ensemble de mots binaires et un additionneur (138) destiné à additionner le contenu du registre et de chaque mot de ladite mémoire partielle (130) de façon qu'en sortie on obtienne l'ensemble de mots binaires correspondant auxdites durées de conduction pour chaque ligne.

7. Dispositif selon l'une quelconque des revendications précédentes, caractérisé en ce que l'interrupteur actif (7) est bi-directionnel en courant.

8. Récepteur de télévision, caractérisé en ce qu'il comprend un dispositif de commande de balayage trame selon l'une quelconque des revendications précédentes.

## Patentansprüche

1. Steuervorrichtung für einen Stromgenerator, der die Vertikalablenkung in einem Fernsehempfänger bewirkt und einen aktiven Unterbrecher (7) aufweist, der von der Vorrichtung gesteuert wird, um im Verlauf einer Zeilenabtastperiode abwechselnd stromdurchlässig und nichtstromdurchlässig zu sein, wobei die Dauer des Stromdurchlasses eine Funktion der Zeilennummer ist, dadurch gekennzeichnet, daß sie zwei Speicher (51, 52), deren Inhalte geändert werden können und die je dazu bestimmt sind, einen Satz Binärwörter zu enthalten, welche je die Dauer des Stromdurchlasses für eine bestimmte Zeile bedeuten, und Umschaltmittel (54, 54', 60, 65, 71) enthält, damit im Verlauf einer Vertikal-Abtastperiode der Inhalt eines Speichers für die Abtastung verwendet wird, während der Inhalt des anderen Speichers verändert werden kann, wobei der geänderte Inhalt im Verlauf der nächsten Vertikal-Abtasperiode verwertet wird, so daß die Änderung ohne Störung des übertragenen Bildes erfolgt.

2. Vorrichtung nach Anspruch 1, dadurch gekennzeichnet, daß die Speicher als Aktivspeicher ausgebildet sind.

3. Vorrichtung nach Anspruch 1 oder 2, dadurch gekennzeichnet, daß sie einen zusätzlichen Speicher (23, 105), in dem für die verschiedenen Zeilen die Sollwerte für die Abtaststromstärke gespeichert sind, ein Mittel zum Vergleich der Soll-Stromstärke mit der gemessenen Stromstärke und ein Mittel aufweist, mit dem der Inhalt des Speichers (51, 52; 130) geändert wird, wenn der Vergleicher eine Abweichung feststellt.

4. Vorrichtung nach Anspruch 3, dadurch gekennzeichnet, daß sie einen Mikroprozessor (23) aufweist, mit dem der Vergleich und die Änderung durchgeführt werden.

5. Vorrichtung nach Anspruch 3 oder Anspruch 4, dadurch gekennzeichnet, daß die im zusätzlichen Speicher enthaltenen Werte die S-Korrektur und/oder die Linearitätskorrektur berücksichtigen.

6. Vorrichtung nach einem beliebigen der vorhergehenden Ansprüche, dadurch gekennzeichnet, daß jeder Speicher, dessen Inhalt geändert werden kann, ein Register (136) umfaßt, in dem ein der kürzesten Dauer ($t_1$) zwischen dem Anfang ($t_0$) einer Zeilenabtastung und der Auslösung des aktiven Unterbreches (7) entsprechendes Binärwort gespeichert ist, sowie einen Teilspeicher (130), der einen Satz Binärwörter enthält, und einen Addierer (138) umfaßt, der dazu bestimmt ist, den Inhalt des Registers mit jedem Wert des Teilspeichers (130) zusammenzuzählen, derart, daß man am Ausgang den Satz Binärwörter erhält, der der Dauer des Stromdurchlasses für jede Zeile entspricht.

7. Vorrichtung nach einem beliebigen der vorhergehenden Ansprüche, dadurch gekennzeichnet, daß der aktive Unterbrecher (7) in beiden Stromrichtungen wirksam ist.

8. Fernsehempfänger, dadurch gekennzeichnet, daß er eine Steuervorrichtung für die Vertikalablenkung nach einem beliebigen der vorhergehenden Ansprüche aufweist.

## Claims

1. A device for controlling a vertical scan deflection current generator of a television receiver, this generator comprising an active switch(7) controlled by said device so as to be alternately conducting and non conducting during each line scanning period, the conduction time depending on the number of the line, characterized in that it comprises two memoires (51, 52), the contents of each of which can be modified and each of which is intended to contain a set of binary words each representing the duration of the conduction time for a particular line, and switch means (54, 54', 60, 65, 71) such that the contents of one memory is used for scanning purposes during one vertical scan period whereas the contents of the other memory can be modified, the modified contents being used during the next vertical scan period such that this modification is carried out without disturbing the retransmitted image.

2. A device according to claim 1, characterized in that the memories are RAM-type memories.

3. A device according to claim 1 or 2, characterized in that it comprises an additional memory (23, 105) in which are stored for the different lines the reference values of scan current intensity, a means for comparing the reference intensity with the measured intensity, and a means for modifying the contents of the memory (51, 52, 130) when the comparator indicates a deviation.

4. A device according to claim 3, characterized in that it comprises a microprocessor (23) for effecting said comparison and said modification.

5. A device according to claim 3 or claim 4, characterized in that the values stored in the additional memory take into account the S and/or linearity correction.

6. A device according to any one of the preceding claims, characterized in that each memory the contents of which can be modified comprises a register (136) in which a binary word corresponding to the shortest duration of time $(t_1)$ elapsing between the beginning $(t_0)$ of a line scan and the triggering of the active switch is stored, a partial memory (130) containing a set of binary words, and an adder (138) intended to add the contents of the register and of each word of the partial memory (130) so that at the output the set of binary words corresponding to said conducting durations for each line is obtained.

7. A device according to one of the preceding claims, characterized in that the active switch (7) is bidirectional as regards the current.

8. A television receiver, characterized in that it comprises a device for controlling the vertical scan deflection according to any one of the preceding claims.

FIG.1

14  15  15'

$t_0$  $t_1$

16  1

17  $t_3$

$t_2$  1

$tf$  $tM$

## FIG.2

48

132  131

133

130  134

135

140

136

139  137

138  +

## FIG.5

# FIG.3

```
                    ┌─────────────────────────────┐
                    │   Attente de la ligne "n"   │
                    └─────────────────────────────┘
                                  │
                    ┌─────────────────────────────┐
                    │    Départ conversion A/N    │
                    └─────────────────────────────┘
                                  │
                    ⟨   Fin de la conversion   ⟩────── non
                                  │ oui
                    ┌─────────────────────────────┐
                    │     Lecture du résultat     │
                    │ (Amplitude du courant dans  │
                    │     le déviateur 2)         │
                    └─────────────────────────────┘
                                  │
                    ⟨     Ampl = Consigne     ⟩────── oui ──┐
                                  │ Non                     │
                    ┌─────────────────────────────┐   ┌──────────────┐
                    │  Delta = Ampl - consigne    │   │ Temporisation│
                    └─────────────────────────────┘   │     1 s      │
                                  │                    └──────────────┘
    non ──── ⟨     Ampl > Consigne     ⟩ ──── oui
         │                                  │
┌──────────────────┐              ┌──────────────────┐
│  RM = RM + Delta │              │  RM = RM - Delta │
└──────────────────┘              └──────────────────┘
         │                                  │
┌──────────────────┐              ┌──────────────────┐
│ Limitation de RM │              │ Limitation de RM │
│ à 0700 (hexadecimal)│           │ à 0400 (hexadecimal)│
└──────────────────┘              └──────────────────┘
         └──────────────┬───────────────────┘
                    ┌─────────────────────────────┐
                    │       MF = TT - RM          │
                    └─────────────────────────────┘
                                  │
                    ┌─────────────────────────────┐
                    │      pas = RM / 625         │
                    └─────────────────────────────┘
                                  │
                    ┌─────────────────────────────┐
                    │     Chargement Mémoire      │
                    │          MF                 │
                    │          MF + pas           │
                    │          MF + 2 pas         │
                    │          etc...             │
                    │     jusqu'à MF + 625 pas    │
                    └─────────────────────────────┘
                                  │
                    ┌─────────────────────────────┐
                    │   Inversion des 2 mémoires  │
                    └─────────────────────────────┘
                                  │
                    ┌─────────────────────────────┐
                    │    Temporisation 20 ms      │
                    └─────────────────────────────┘
```

13

# FIG.4